# EUROPÄISCHE PATENTSCHRIFT

(11) **EP 2 599 135 B1**
(45) Veröffentlichungstag und Bekanntmachung des Hinweises auf die Patenterteilung: **10.09.2014**
(21) Anmeldenummer: 11729277.1
(22) Anmeldetag: 15.06.2011
(51) Int. Cl.: H01L 39/24

(54) **HOCHTEMPERATUR-SUPRALEITER-BANDLEITER MIT HOHER KRITISCHER STROMTRAGFÄHIGKEIT**
HIGH TEMPERATURE SUPERCONDUCTING TAPE CONDUCTOR HAVING HIGH CRITICAL AMPACITY
CONDUCTEUR À BANDE SUPRACONDUCTEUR À TEMPÉRATURE ÉLEVÉE À COURANT ADMISSIBLE CRITIQUE ÉLEVÉ

(30) Priorität: 29.07.2010 DE 102010038656
(43) Veröffentlichungstag der Anmeldung: 05.06.2013
(73) Patentinhaber: Theva Dünnschichttechnik GmbH, 85737 Ismaning (DE)
(72) Erfinder: SEMERAD, Robert, 84427 Armstorf (DE); PRUSSEIT, Werner, 80799 München (DE)
(74) Vertreter: Wegner, Hans
(86) Internationale Anmeldenummer: PCT/EP2011/059956
(87) Internationale Veröffentlichungsnummer: WO 2012/013415

(56) Entgegenhaltungen:
- US-A- 5 434 126
- US-A1- 2001 007 707
- US-A1- 2009 082 211
- VALENTINA ROXANA VLAD ET AL: "Growth of Chemical Solution Deposited Coated Conductors", IEEE TRANSACTIONS ON APPLIED SUPERCONDUCTIVITY, IEEE SERVICE CENTER, LOS ALAMITOS, CA, US, Bd. 19, Nr. 3, 1. Juni 2009 (2009-06-01), Seiten 3212-3215, XP011263759, ISSN: 1051-8223

## Beschreibung

### 1. Technisches Gebiet

Die vorliegende Erfindung betrifft einen Hochtemperatur-Supraleiter-Bandleiter.

### 2. Stand der Technik

Im Folgenden wird als Hochtemperatur-Supraleiter-Bandleiter (HTS-Bandleiter) oder auch nur Bandleiter eine supraleitende Leiterkonfiguration bezeichnet, die auf einer flexiblen Metallsubstratfolie basiert, auf die auf einer oder mehreren Zwischenschichten mindestens eine HTS-Schicht als supraleitende, stromführende Funktionsschicht aufgebracht wird. Die eine oder die mehreren Zwischenschichten - auch als Pufferschichten bezeichnet - können beispielsweise als Diffusionsbarriere wirken oder eine kristalline Orientierung bereitstellen und als Epitaxieunterlage für die HTS-Schicht dienen.

HTS-Bandleiter stellen in der Elektro- und Energietechnik ein Standardleitermaterial dar, aus dem Leitungen, Kabel oder Windungen und Spulen hergestellt werden. Die charakteristische Größe zur Qualitätsbewertung bzw. zum Ausdruck der Leistungsfähigkeit von HTS-Bandleitern ist die kritische Stromtragfähigkeit bis zu der der Leiter den elektrischen Strom ohne merklichen Widerstand transportiert. Eine hohe ingenieurtechnische Stromdichte, d.h. der übertragbare Strom pro Gesamtleiterquerschnitt, bedeutet dabei, dass sehr hohe Ströme und Leistungen auf sehr geringem Raum (Querschnitt) übertragen werden können.

Je höher die Stromdichte desto kompakter können elektrische Systeme wie Kabel, Motoren, Spulen etc. gebaut werden. In Wechselstromanwendungen hängen überdies die im Supraleiter auftretenden geringen Wechselstromverluste stark von dem Verhältnis I/I_{C}, d.h. dem Transportstrom I zum kritischen Strom Ic ab (Supercond. Sci. Technol. 22 (2009) 055014; Physica C 445-448 (2006) 712). Eine Verdopplung von Ic führt danach bei gleicher Transportstrombelastung zu einer Reduktion der Wechselstromverluste um eine Größenordnung. Auch der Preis von HTS-Bandleitern wird üblicherweise auf die Leistungsfähigkeit bezogen und in EUR pro Kiloampere - Meter (€/kA·m) angegeben. Da die Stromtragfähigkeit allein durch die HTS-Schicht gegeben ist, führt eine Verbesserung dieser Schicht zu einer Verringerung der leistungsbezogenen Herstellungskosten, da die Kosten der übrigen Herstellungsschritte (Substrat, Zwischenschichten, etc.) unverändert bleiben. Die Steigerung des kritischen Transportstroms ist deshalb ein zentrales Ziel bei der Herstellung anwendungsoptimierter HTS-Bandleiter.

Eine unmittelbare naheliegende Maßnahme wäre die Steigerung der HTS-Schichtdicke, so dass der effektive HTS-Leiterquerschnitt steigt und damit die Stromtragfähigkeit linear zur Schichtdicke wächst. In der Praxis beobachtet man jedoch, dass sich die spezifische Stromtragfähigkeit der HTS-Schicht mit steigender Schichtdicke verschlechtert bis zu dem Punkt, dass eine zusätzliche Schichtdicke zu keiner weiteren Erhöhung der Stromtragfähigkeit führt. Bei zusätzlicher Schichtdicke handelt es sich also nur noch um totes Material, das nicht zum Stromtransport beiträgt. Qualitativ hochwertige HTS-Schichtdicken sind deshalb bis heute auf Dicken unter 3 - 5 µm begrenzt.

Bei Hochtemperatur-Supraleitern (HTS) handelt es sich um oxidkeramische Supraleiter, bei denen CuO₂-Ebenen zentrale Bestandteile im kristallinen Gefüge darstellen. Typische Vertreter dieser Materialklasse sind die Verbindungen mit der chemischen Summenformel RBa₂Cu₃O₇, im Folgenden stellvertretend verkürzt als RBCO bezeichnet, wobei R für ein Element aus der Gruppe der Seltenerden (z.B. Dy, Gd, Ho, etc.) oder für Yttrium (Y) steht.

Ein unverwechselbares Merkmal der HTS ist ihre starke kristalline Anisotropie. Die CuO₂-Ebenen werden im Kristall durch die sogenannten a-b-Achsen aufgespannt, während die Richtung senkrecht dazu als c-Achse bezeichnet wird. Die kristalline Anisotropie hat Auswirkungen auf praktisch alle physikalischen und elektronischen Eigenschaften der HTS, wie u.a. auf die supraleitende Stromtragfähigkeit, die Diffusionskoeffizienten entlang bestimmter Richtungen und die Kristallwachstumsgeschwindigkeiten.

Werden HTS mit physikalischen oder chemischen Verfahren als dünne Schichten auf einem Substrat abgeschieden, so bestehen diese aus vielen individuellen Kristalliten oder Körnern. Weicht deren kristalline Orientierung stark voneinander ab, behindern die dazwischen liegenden Großwinkelkorngrenzen den supraleitenden Stromfluss derart, dass die kritische Stromtragfähigkeit um mehrere Größenordnungen unter der intrinsischen Stromtragfähigkeit der Einzelkörner liegt. In HTS-Bandleitern mit hoher Stromtragfähigkeit müssen deshalb die Körner innerhalb einer Schwankungsbreite von einigen Grad gut zueinander ausgerichtet sein.

Mit den üblichen Beschichtungstechniken werden deshalb biaxial texturierte HTS-Schichten hergestellt, bei denen die a-b-Achsen in fester Beziehung zur Unterlage parallel zur Substratoberfläche liegen und die c-Achse senkrecht dazu steht. Man spricht von c-Achsen-Orientierung der Schicht. Üblicherweise erreicht man diese Ausrichtung auch auf einer makroskopischen Längenskala mit Hilfe eines Epitaxieprozesses, d.h. eine geeignete Unterlage gibt die Wachstumsrichtung der kristallinen HTS-Schicht vor. Geeignete Unterlagen sind beispielsweise einkristalline Scheiben aus Saphir, MgO, LaAlO₃, etc., deren Kristallsymmetrie und Gitterkonstante an die der HTS-Schicht angepasst sind. Auch einige Metalle lassen sich durch mechanische Deformation und Auslagerung so vorbehandeln, dass eine dünne Metallfolie mit gut zueinander ausgerichteten Körnern entsteht. Dies ist als sogenanntes RABiTS-Verfahren Stand der Technik (US 5 964 966).

Die US 2008/0113869 A1 offenbart ein supraleitendes Element, das ein Substrat umfasst, wobei das Substrate nicht texturiert ist und eine Nickel basierte Legierung umfasst, die hauptsächlich Nickel und nicht weniger als 20 Gewichts-% eines Legierungselements enthält und wobei das Substrat im Wesentlichen frei von Molybdän und Mangan ist. Ferner umfasst das supraleitende Element eine Bufferschicht, die auf dem Substrat aufliegt und eine Hochtemperatur-Supraleiterschicht (HTS), die auf der Bufferschicht aufliegt.

Die Kristallite in vielen Metallen und Legierungen lassen sich jedoch nicht auf derart einfache Weise ausrichten. In diesen Fällen greift man auf Verfahren zurück, um eine Pufferschicht, die direkt oder mit Zwischenschichten auf dem Metallsubstrat abgeschieden wird, durch geeignete Prozessführung auszurichten, um damit für weitere Beschichtungen eine epitaxiefähige Unterlage bereitzustellen. Dadurch wird u.a. auch das Wachstum biaxial orientierter HTS-Schichten ermöglicht. In der Technik kommen dafür im Wesentlichen zwei PVD-Verfahren (Physical Vapor Deposition) zum Einsatz: "Ion Beam Assisted Deposition" (IBAD) oder "Inclined Substrate Deposition" (ISD). Beim IBAD-Verfahren bewirkt ein während der Beschichtung zusätzlich auf die Schicht gerichteter Ionenstrahl die gewünschte Ausrichtung (EP o 872 579, US 5 432 151), während beim ISD-Verfahren die Orientierung durch Wachstumsselektion entsteht, wenn das Substrat gegen die Einfallsrichtung des auftreffenden Beschichtungsmaterials verkippt wird (EP o 909 340, EP 0 669411).

Die DE 197 54 475 A1 der Anmelderin offenbart ein Schichtmaterial mit der Reihe nach einem amorphen oder polykristallinen Substrat, einer texturierten Pufferschicht und einer orientierten Dünnschicht, wobei zwischen der Pufferschicht und der Dünnschicht wenigstens eine Deckschicht enthalten ist. Mit der wenigstens einen Deckschicht wird erreicht, dass hersellungsbedingte Lücken und Unebenheiten in der Pufferschicht ausgeglichen werden, so dass die orientierte oxidische Dünnschicht entsprechend der für ihr Aufwachsen zu Verfügung stehenden Oberfläche der Deckschicht eine hohe Qualität aufweist.

Bei perfekter Epitaxie sollte die kritische Stromdichte in der HTS-Schicht von der Schichtdicke völlig unabhängig sein und hohe Transportströme könnten einfach durch Erhöhung der HTS-Schichtdicke erreicht werden. In der Praxis beobachtet man jedoch eine starke Degradation der kritischen Stromdichte mit wachsender Schichtdicke, so dass es bislang kaum gelingt, in dicken HTS-Schichten oberhalb von 3 ₋ 5 µm noch einen deutlichen Zuwachs des Transportstroms zu erzielen. Einige mögliche Hauptgründe für diese starke Schichtdickenabhängigkeit sollen nachfolgend kurz erläutert werden.

Unterschiedliche thermische Ausdehnungskoeffizienten zwischen dem Substrat und der HTS-Schicht können dazu führen, dass die HTS-Schicht, die üblicherweise bei hohen Temperaturen > 650°C abgeschieden wird, beim Abkühlen verspannt ist. Die meisten gängigen oxidischen Substratmaterialien wie z.B. Saphir, LaAlO₃, YSZ (Yttrium stabilisiertes Zirkonoxid), aber auch Silizium besitzen deutlich kleinere Wärmeausdehnungskoeffizienten als die HTS-Schicht, so dass diese unter Zugspannung gerät. Ab einer bestimmten Schichtdicke wird diese durch Risse relaxiert, wodurch der kritische Strom um mehrere Größenordnungen sinkt oder gar kein zusammenhängender supraleitender Strompfad mehr durch die Schicht führt (W. Prusseit et al., Physica C 201, (1992), 249-256).

Aus der Literatur sind Ansätze bekannt, dieser Problematik durch Einführung einer gewissen Porosität in die HTS-Schicht zu begegnen. Poriges Wachstum ermöglicht der Schicht, Spannungen besser aufzunehmen oder die Ausbreitung von Mikrorissen durch Poren zu stoppen. Auf Saphir ist z.B. die kritische Schichtdicke von YBa₂Cu₃O₇ bei ca. 300 - 400 nm erreicht. Porosität kann z.B. durch einen Yttrium-Überschuss im Film (K. Develos-Bagarinao, H. Yamazaki, in: YBCO Superconductor Research Progress, Ed.: Li-Chun Liang, S53 - 92, Nova Science Publ. (2008), ISBN: 978-1-60456-083-1) oder durch Wachstum auf Substraten erreicht werden, die mit einigen Grad Abweichung von der perfekten Epitaxieorientierung geschnitten und poliert wurden (Appl. Phys. Lett. 86 (19) (2005) 192507, IEEE Trans. Appl. Supercond. 17, (2007), 3459-3462). Letzteres bedeutet, dass die Kristallachse (c-Achse) leicht, typischerweise um 1° - 6°, von der Substratnormale abweicht. Dadurch ließen sich auf Saphir rissfreie YBa₂Cu₃O₇ Schichten von bis zu 1 µm Dicke herstellen. Allerdings führt die Porosität auch zu Einbußen in der Stromdichte, so dass netto kaum eine Verbesserung des Transportstroms beobachtet wurde.

Auf metallischen Substraten spielt der Effekt der thermischen Ausdehnung zumeist keine Rolle, da die Ausdehnungskoeffizienten der Metalle größer sind als die der HTS-Schicht, so dass diese lediglich unter Druckspannung kommt und keine Rissbildung auftritt. In den HTS-Schichten von Bandleitern können deshalb prinzipiell selbst Schichtdicken von mehreren Mikrometern realisiert werden. Allerdings beobachtet man auch dort eine starke Abhängigkeit der kritischen Stromdichte von der Schichtdicke (Appl. Phys. Lett. 75, (1999), 3692-3694).

Ausprägung und Ursachen dieser Abhängigkeit sind oft im Herstellungsverfahren begründet. Tatsächlich erfolgt das Schichtwachstum niemals perfekt, sondern es treten Wachstumsdefekte, wie z.B. fehlorientierte Körner (zumeist a-Achsen- Körner) oder Fremdphasen auf. Sind diese einmal entstanden, so verschwinden sie im Laufe des weiteren Schichtwachstums nicht mehr, vielmehr reichern sie sich in der Schicht an oder wachsen zu solcher Größe, dass sie den Stromfluss effektiv behindern. In RBCO beobachtet man oft die Entstehung von a-Achsen-orientierten Körnern, da die Gitterkonstante in c-Richtung ziemlich genau dem Dreifachen des a-Achsen Gitterparameters entspricht und für beide Orientierungen gleichermaßen ähnliche Epitaxiebedingungen erfüllt sind. Da auch die Kristallwachstumsgeschwindigkeiten in HTS stark anisotrop sind und Kristallite in a-Richtung viel schneller wachsen als in c-Richtung, machen sich diese Körner in der Schicht als eingelagerte Nadeln oder Plättchen bemerkbar, die wie Wände den Stromfluss behindern. Mit wachsender Schichtdicke entstehen bei konstanter Nukleationsrate immer mehr solcher Körner, die aufgrund ihres Längenwachstums schließlich ein Netz senkrecht aufeinander treffender Wände bilden. Weiteres Schichtwachstum führt deshalb nur noch zu einer toten oberflächennahen Schicht, die keinen Beitrag mehr zum Transportstrom leistet.

Will man hohe Ströme durch Aufdicken der HTS-Schicht erreichen, gilt es deshalb, diese Defekte zu unterdrücken oder deren Wachstum stark zu begrenzen. Dazu sind im Stand der Technik lediglich zwei erfolgreiche Ansätze bekannt. Zum einen wurde versucht, durch eine periodische Abfolge von Doppellagen aus YBa₂Cu₃O₇ (500 nm) und CeO₂ (30nm), die in der HTS-Schicht entstehenden Defekte durch die dünnen CeO₂ Zwischenschichten zu überwachsen oder auszugleichen, so dass für die darauf folgende HTS-Schicht wieder eine möglichst perfekte Unterlage zur Verfügung steht (Appl. Phys. Lett. 87 (2005), 162505). Mit diesem Verfahren konnten Bandleiterstücke mit 3,5 µm dicken HTS-Multilagen und einer kritischen Stromtragfähigkeit von 1400 A/cm (bei 75 K) hergestellt werden. Die abwechselnde Abscheidung zweier Komponenten stellt jedoch produktionstechnisch eine Komplikation und einen unerwünschten Kostenfaktor dar.

Zum anderen wurde durch eine besonders gleichmäßige Hohlraum-Strahlungsheizung während der Bandbeschichtung versucht, die Temperatur während der HTS-Beschichtung möglichst konstant zu halten und damit ideale Voraussetzungen für das Wachstum zu schaffen. Durch diese Anordnung konnten bis zu 6 µm dicke GdBCO-Schichten mit ca. 1000 A/cm (bei 77 K) abgeschieden werden. Allerdings ist die Verwendung dieses Heizerkonzepts beschränkt auf das dort verwendete PLD-Beschichtungsverfahren (Pulsed Laser Deposition), da dieses mit einer relativ kleinen Beschichtungsöffnung in der Heizerwandung auskommt. Das PLD-Verfahren zählt jedoch eher zu den teuren Labortechniken und erscheint für eine großtechnische, kostengünstige Bandleiterherstellung ungeeignet.

Ein weiteres generelles Problem dicker HTS-Schichten besteht in deren ausreichender Sauerstoffbeladung. Während der Schichtherstellung bei hohen Temperaturen > 650°C entsteht zunächst die halbleitende, tetragonale RBa₂Cu₃O₆-Phase. Erst beim Abkühlen im Sauerstoff wird im Zuge eines strukturellen Phasenübergangs ein siebtes Sauerstoffatom in die Einheitszelle eingebaut, was zur supraleitenden, orthorhombischen RBa₂Cu₃O₇₋₈ führt, wobei ein leichtes Sauerstoffdefizit δ < 0,15 keine negativen Auswirkungen auf die Stromtragfähigkeit hat und vertretbar ist. Beim Abkühlen im Sauerstoff gilt es jedoch die Schicht in ihrer gesamten Dicke bis zur Unterlage ausreichend mit Sauerstoff zu beladen.

Die Sauerstoffdiffusion in der HTS-Schicht ist jedoch ebenfalls stark anisotrop. So ist z.B. in YBCO die Diffusionskonstante D_{c} in c-Richtung um vier bis fünf Zehnerpotenzen kleiner als die Diffusionskonstante D_{ab} in ab-Richtung (J. Appl. Phys. 69 (1991), 7189-7201). Obwohl selbst perfekt c-Achsen-orientierte HTS-Schichten wachstumsbedingt mit Korngrenzen senkrecht zur Oberfläche durchzogen sind, spielt die langsame Diffusionsgeschwindigkeit in c-Richtung für die Prozesszeiten bei der abschließenden Beladung mit Sauerstoff eine große Rolle. Wird bei dicken Filmen die Beladungszeit nicht drastisch erhöht, so werden tiefer liegende Bereiche der HTS-Schicht nicht ausreichend mit Sauerstoff beladen und fallen damit für den Stromtransport aus. Die vollständige Beladung dicker Schichten kann extrem lange Prozesszeiten nötig machen, was in der Produktion den Durchsatz pro Anlage limitiert.

Der vorliegenden Erfindung liegt daher das Problem zu Grunde, einen HTS-Bandleiter mit einer großen Stromtragfähigkeit anzugeben, der die oben diskutierten Nachteile zumindest zum Teil vermeidet.

### 3. Zusammenfassung der Erfindung

Gemäß einem Ausführungsbeispiel der vorliegenden Erfindung wird dieses Problem durch einen HTS-Bandleiter nach Anspruch 1 gelöst. In einer Ausführungsform weist der Hochtemperatur-Supraleiter-Bandleiter mit einem flexiblen Metallsubstrat zumindest eine Zwischenschicht auf, die auf dem flexiblen Metallsubstrat angeordnet ist und die auf der dem flexiblen Metallsubstrat gegenüberliegenden Seite Terrassen aufweist, wobei eine mittlere Breite der Terrassen kleiner als 1 µm ist und eine mittlere Höhe der Terrassen größer als 20 nm ist, und zumindest eine auf der Zwischenschicht angeordnete Hochtemperatur-Supraleiter-Schicht, die auf der zumindest einen Zwischenschicht angeordnet ist und eine Schichtdichte größer als 3 µm aufweist, und wobei die auf die Leiterbreite bezogene Stromtragfähigkeit des Hochtemperatur-Supraleiter-Bandleiters bei 77 K größer als 600 A/cm ist.

Der definierte HTS-Bandleiter kann auch bei großen Schichtdicken sehr hohe Transportströme tragen. Dies ist wird dadurch erreicht, dass beim Herstellen eines erfindungsgemäßen HTS-Bandleiters der Wachstumsmodus der HTS-Schicht so gesteuert wird, dass die wichtigsten der oben beschriebenen Ursachen für eine Degradation der kritischen Stromdichte mit wachsender Schichtdicke unterdrückt werden. Insbesondere erzwingt ein terrassierter HTS-Wachstumsmodus, dass die in die supraleitenden a-b-Ebenen eingelagerten Defekte überwachsen werden können. Besonders günstig erweist sich dabei, wenn die a-b-Ebenen der HTS-Schicht unter einem schrägen Winkel zur Substratoberfläche stehen. Das Terrassenwachstum der Schicht erlaubt die Steigerung der HTS-Schichtdicke über 3 µm hinaus, ohne dass starke Leistungseinbußen hinsichtlich der erzielten Stromdichte in Kauf genommen werden müssen. Dadurch lässt sich die Stromtragfähigkeit von HTS-Bandleitern deutlich gegenüber dem Stand der Technik steigern. Eine Terrasse kann auch als eine Facette bezeichnet werden, d.h. als eine - bis auf für das Schichtwachstum der HTS-Schicht vernachlässigbare Abweichungen - plane Oberfläche der Zwischenschicht.

In einem weiteren Aspekt weist die Hochtemperatur-Supraleiter-Schicht eine Schichtdicke von 5 µm bis 10 µm auf.

Gemäß einem anderen Aspekt umfasst die mittlere Höhe der Terrassen der zumindest einen Zwischenschicht einen Bereich von 50 nm bis 200 nm.

Nach einem weiteren Aspekt überschreitet die maximale mittlere Höhe der Terrassen der zumindest einen Zwischenschicht 20% der Schichtdicke der Hochtemperatur-Supraleiter-Schicht nicht.

In noch einem anderen Aspekt ist die mittlere Breite der Terrassen der zumindest einen Zwischenschicht kleiner als 400 nm.

Gemäß einem weiteren Aspekt umfasst das Metallsubstrat eine Folie aus Hastelloy mit einer Dicke bis 200 µm.

In einem anderen vorteilhaften Aspekt umfasst die zumindest eine Zwischenschicht eine Magnesiumoxid-Schicht mit einer Dicke von 1,5 µm bis 3,5 µm.

Nach einem weiteren Aspekt umfasst die Hochtemperatur-Supraleiter-Schicht eine RBa₂Cu₃O₇ Schicht umfasst, wobei R ein Elemente aus der Gruppe umfasst, die die Elemente Dysprosium (Dy), Gadolinium (Gd), Holmium (Ho) und Yttrium (Y) beinhaltet, insbesondere eine Hochtemperatur-Supraleiter-Schicht aus DyBa₂Cu₃O₇.

In noch einem anderen Aspekt ist die Oberfläche der Terrassen im Wesentlichen parallel zu der Metallsubstratebene.

Gemäß einem weiteren Aspekt werden die Terrassen der zumindest einen Zwischenschicht durch anisotropes Ätzen hergestellt.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: den Verlauf der kritischen Stromdichte von 0,8 µm dicken YBCO- Schichten als Funktion des Verkippungswinkels des MgO-Substrats wiedergibt und die Beziehung der kristallographischen Orientierung in dem Substrat und der HTS-Schicht angibt;
- Fig. 2: die kritische Stromdichte von YBCO-Schichten unterschiedlicher Dicke auf MgO-Substraten mit unterschiedlichem Verkippungswinkel zeigt;
- Fig. 3: eine elektronenmikroskopische Aufnahme einer gestuften, verkippten MgO-Oberfläche zeigt, die nach dem ISD-Verfahren hergestellt wurde;
- Fig. 4: Querschnittskizzen senkrecht zu den Oberflächen kristalliner Unterlagen mit verkippter Kristallachse darstellt, A) ein schräg geschnittener und polierter Einkristall, B) eine durch das ISD-Verfahren hergestellte Schicht; wobei sowohl die Richtungen der c-Achse als auch die Normale der Terrassenoberflächen um den Winkel β von der Substratnormale abweichen;
- Fig. 5: einen schematischen Querschnitt zeigt: Wachstum von a-Achsen-orientierten Körnern in c-Achsen-orientierten HTS-Filmen auf glatter (A) und gestufter (B) Unterlage;
- Fig. 6: einen schematischen Querschnitt angibt: Wachstum und Einlagerung von Fremdphasen in c-Achsen-orienderte HTS-Schichten auf glatter (A) und gestufter (B) Unterlage;
- Fig. 7: eine elektronenmikroskopische Querschnittaufnahme einer DyBCO-Schicht auf einer ISD-MgO-Schicht eines HTS-Bandleiters darstellt;
- Fig. 8: die Stromtragfähigkeit von DyBCO-Schichten unterschiedlicher Dicke in Bandleitern mit ISD-MgO-Pufferschicht wiedergibt; und
- Fig. 9: einen schematischen Querschnitt angibt, der das Wachstum und die Einlagerung von Fremdphasen und a-Achsen-Körnern in c-Achsen-orientierte HTS-Schichten auf einer stufigen Unterlage ohne kristallographische Verkippung veranschaulicht.

### 5. Detaillierte Beschreibung bevorzugter Ausführungsbeispiele

Im Folgenden wird zunächst der Begriff kritischer Strom erläutert und danach werden derzeit bevorzugte Ausführungsformen eines erfindungsgemäßen HTS-Bandleiters genauer erläutert.

Supraleiter können elektrischen Gleichstrom bis zum Erreichen einer gewissen kritischen Stromdichte verlustfrei transportieren. Wird dieser kritische Wert erreicht oder überschritten, treten durch Bewegung magnetischer Flusslinien im Supraleiter merkliche elektrische Verluste auf. Üblicherweise wird in der Technik ein 1 µV/cm - Kriterium benutzt, um das Erreichen der kritischen Stromdichte, d.h. des Stroms bezogen auf den HTS-Schichtquerschnitt, zu definieren. Der kritische Transportstrom ergibt sich aus dem Produkt der kritischen Stromdichte und dem HTS-Schichtquerschnitt. Bei HTS-Bandleitern wird oft auch der auf die Leiterbreite bezogene kritische Strom in A/cm benutzt. Wenn nicht anders angegeben, beziehen sich die Werte auf eine Messtemperatur von 77K. Die ingenieurtechnische Stromdichte ist schließlich die Stromdichte des fertigen, technischen Bandleiters und ergibt sich aus dem Quotienten der kritischen Stromstärke und dem Gesamtleiterquerschnitt inklusive Substrat und anderer Schichten, bzw. Laminierungen.

Unabhängig von den aus dem Stand der Technik bekannten Maßnahmen wie der Multischichtabscheidung oder der exakten Temperaturkontrolle, kann auch der Wachstumsmodus der HTS-Schicht so gesteuert werden, dass die wichtigsten der oben beschriebenen Ursachen für eine Degradation der kritischen Stromdichte mit wachsender Schichtdicke unterdrückt werden. Erfindungsgemäß wird dies erreicht durch ein terrassenartiges Schichtwachstum. Besonders günstig erweist sich dabei, wenn die a-b-Ebenen der HTS-Schicht unter schrägen Winkel zur Substratoberfläche stehen. Besonders gute Ergebnisse werden erzielt, wenn dieser Verkippungswinkel zwischen 5°-30° liegt.

Für die Herstellung von HTS-Bandleitern kann eine derartige Unterlage beispielsweise durch das ISD-Verfahren gemäß der Patentschrift EP o 909 340 mit seiner verkippten MgO-Pufferschicht bereit gestellt werden. Um die Einflüsse der Abweichung von der (100)-Orientierung und der Oberflächenmorphologie von MgO-Substraten auf das HTS-Schichtwachstum getrennt voneinander zu untersuchen, wurden zunächst Beschichtungsexperimente auf fehlorienderten, polierten MgO-Einkristallen durchgeführt. Der Verkippungswinkel ist gegenüber der [001]-Richtung angegeben, so dass 0° ein perfekt (100)-orientiertes MgO-Substrat bezeichnet. Die Verkippung erfolgt in [110]-Richtung, d.h. zur Kante der kubischen MgO-Einheitszelle hin.

Auf MgO-Substraten mit unterschiedlicher Fehlorientierung wurden YBCO-Filme durch Elektronenstrahlverdampfen von YBCO-Granulat gemäß dem Dokument EP 1558 782 abgeschieden. Die Ergebnisse für YBCO-Schichten mit einer Schichtdicke von 0,8 µm sind in Tabelle 1 zusammengefasst. In der ersten Zeile ist der Verkippungswinkel des MgO-Substrats gegenüber der [001]-Richtung aufgetragen, während die zweite Zeile die durch Röntgenbeugung ermittelte Verkippung der YBCO c-Achse zur Substratnormale angibt. Die Qualität der Supraleiterschicht ist durch die induktiv gemessene kritische Stromdichte in der dritten Zeile charakterisiert.

**Tabelle 1: HTS Beschichtungsergebnisse auf verkippten MgO-Substraten**

| MgO-Verkippungswinkel | 0° | 3° | 5° | 7° | 10° | 15° | 20° |
|---|---|---|---|---|---|---|---|
| YBCO-Verkippungswinkel | 0° | 3° | 5° | 7° | 10° | 0° | 0° |
| jc (77K) in MA/cm² | 3,31 | 3,81 | 3,98 | 3,91 | 2,98 | 2,5 | <1* |

Bis zu einer Substratverkippung von ca. 10° vermag die HTS-Schicht offenbar der Vorgabe durch das Substrat zu folgen, was in der analogen Verkippung der c-Achse zum Ausdruck kommt. Wird der Verkippungswinkel weiter erhöht, folgt die HTS-Schicht jedoch nicht mehr der Unterlage. Die starke Fehlorientierung der Substratoberfläche wird offenbar durch den Einbau von Versetzungen ausgeglichen, so dass die c-Achse der HTS-Schicht senkrecht auf dem Substrat stehen kann. Bei einer sehr starken Fehlorientierung von 20° hängt das Ergebnis (Stern-Markierung) stark von der Richtung der Verkippung ab, da sich in bestimmten Richtungen bereits wieder neue günstige Epitaxiebedingungen ergeben können.

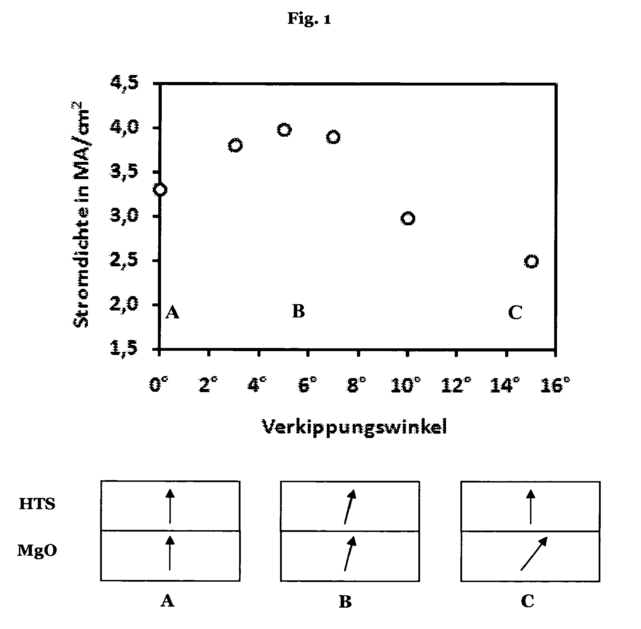

Generell beobachtet man bei sehr großen Winkeln zwar immer noch eine c-Achsen-Textur, Röntgen-Polfiguren zeigen jedoch auch, dass innerhalb der Substratebene keine eindeutig definierte Kristallorientierung in der HTS-Schicht mehr vorliegt. Das Ergebnis ist nochmals graphisch in der Fig. 1 veranschaulicht. Die kritische Stromdichte steigt bei kleinen Verkippungswinkeln deutlich an, erreicht zwischen 5° - 7° ein Maximum und fällt zu größeren Winkeln hin drastisch ab. Die Orientierungsbeziehungen zwischen dem Substrat und dem HTS-Film sind in den Bereichen (A, B, C) darunter skizziert.

Während offenbar Versetzungen und Poren bei leichter Verkippung zusätzliche Haftzentren (Pinningzentren) für die Flussfäden darstellen, was die kritische Stromtragfähigkeit ansteigen lässt, führen die Art und die zunehmende Dichte der Defekte bei größeren Winkeln zu einer massive Beeinträchtigung des Kristallgitters und der Supraleitungseigenschaften. Die Untersuchung belegt, dass eine Fehlorientierung der Unterlage zu einem gewissen Maße eine Verbesserung der kritischen Stromdichte ermöglicht. Auf MgO-Substraten erscheint eine Verkippung über 5° - 7° hinaus jedoch nicht angeraten.

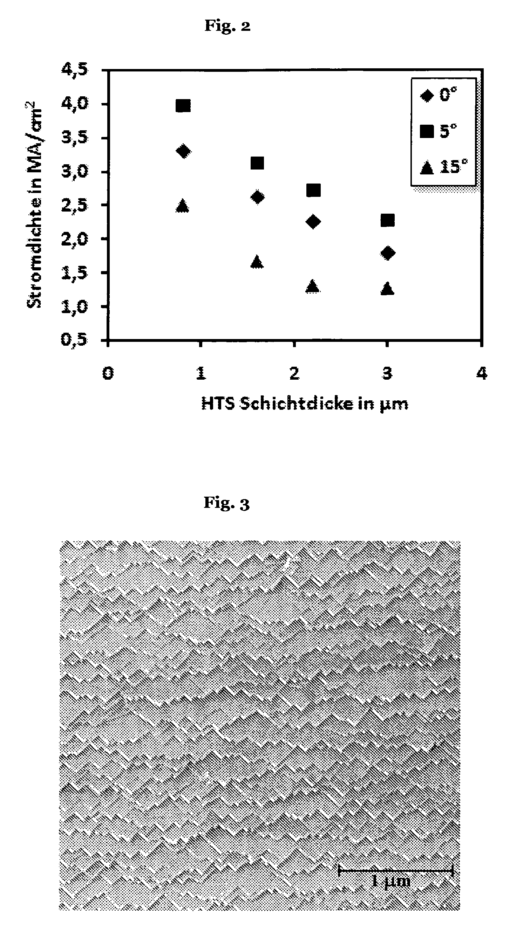

Als nächstes wurde die Auswirkung der Verkippung auf das Schichtdickenwachstum und die Qualität dicker HTS-Schichten untersucht. Dazu wurden auf allen MgO-Substraten der Untersuchungsreihe HTS-Schichten bis zu einer Dicke von 3 µm abgeschieden. Das Ergebnis ist beispielhaft für drei Verkippungswinkel in der Fig. 2 dargestellt. Obwohl die Verkippung den oben beschriebenen, positiven Effekt auf die Absolutwerte der kritischen Stromdichte aufweist, fallen diese mit wachsender Schichtdicke, unabhängig davon, ob das Substrat verkippt ist oder nicht, kontinuierlich ab. Ein positiver Effekt der Substratverkippung auf das Schichtdickenwachstum konnte also nicht beobachtet werden.

Neben der absichtlichen Fehlorientierung einkristalliner Substrate durch schräges Schneiden und Polieren stellt zum Beispiel das ISD-Verfahren eine weitere Möglichkeit zur Bereitstellung einer fehlorientierten Unterlage dar. Bei diesem Verfahren wird ein Pufferschichtmaterial, bevorzugt MgO, unter schrägem Winkel auf einer polykristallinen oder amorphen Unterlage abgeschieden. Dabei bilden sich charakteristische Wachstumssäulen, deren (100)-Oberflächen dem einfallenden Material zugeneigt sind. Durch Wachstumsselektion besteht die MgO-Oberfläche aus biaxial orientierten Kristalliten, die innerhalb einer Winkelstreubreite von 5° - 15° in der Ebene dieselbe Ausrichtung besitzen. Die [001]-Richtung der resultierenden MgO-Oberfläche ist dabei je nach Einfallswinkel um 15° - 30° zur Substratnormale verkippt. Es handelt sich also um eine relativ starke Verkippung. Die Oberfläche dieser MgO-Schicht unterscheidet sich durch eine charakteristische Facettierung oder Terrassenstruktur deutlich von den oben betrachteten schräg geschnittenen, aber glatten Einkristallen. Diese erinnert an ein Schindeldach und ist in der elektronenmikroskopischen Aufsicht in der Fig. 3 gezeigt.

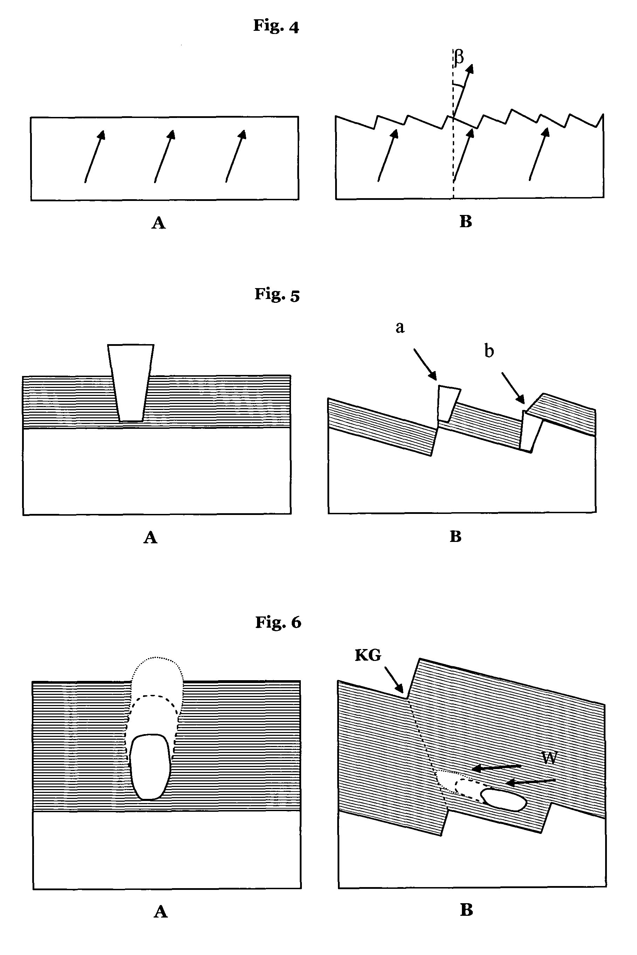

Die Fig. 4 veranschaulicht im schematischen Querschnitt den charakteristischen Unterschied zwischen zwei Substraten mit verkippter Orientierung (Pfeile), aber glatter Oberfläche (A) und einer Oberfläche, die aus Terrassen besteht, die um den Winkel β gegenüber der Substratnormale verkippt sind (B).

Benutzt man eine derartig terrassierte Epitaxieunterlage für das HTS-Wachstum, so unterscheidet sich dieses erheblich und in charakteristischer Weise von dem HTS-Wachstum auf einem Substrat mit glatter Oberfläche. Während die HTS-Schicht auf einem glatten Substrat an der Grenzfläche Fehlstellen durch Versetzungen ausgleichen muss, um der Verkippung zu folgen oder sich bei großen Winkel abweichungen von der idealen Epitaxieunterlage völlig unabhängig auszurichten, kann die Schicht auf den einzelnen Facetten (Terrassen) der terrassierten Oberfläche in einer Art Mikroepitaxie wie auf einem optimal orientierten (nicht fehlorientierten) Einkristall keimen und wachsen. Die Oberfläche wirkt wie eine Ansammlung kleiner, schräg gestellter, aber ansonsten perfekt c-Achsen-orientierter Einkristalle. Die HTS-Schicht übernimmt die relativ zur globalen Substratebene starke Verkippung. Dieses HTS-Wachstum ist gegenwärtig in der Bandleiterherstellung charakteristisch für das ISD-Verfahren und lässt sich auf sehr einfache Weise, z.B. durch Röntgenbeugung nachweisen.

Der prinzipielle Unterschied in der Auswirkung der Wachstumsmodi auf die Bildung und das Wachstum von häufigen Defekten in HTS-Schichten ist in den Figuren 5 und 6 skizziert. Auf einem glatten Substrat (Fig. 5 A) können a-Achsen-Körner, bei denen die c-Richtung in der Substratebene liegt, aufgrund der schnelleren Wachstumsgeschwindigkeit in a-b-Richtung trapezförmig aus der Schicht heraus wachsen und sind damit nicht in der Größe limitiert.

Dagegen sind HTS-Körner, die auf den Terrassen einer gestuften Oberfläche mit ausreichender Stufenhöhe (Fig. 5 B) keimen, im Wesentlichen durch die Breite der Terrassen begrenzt. Das Terrassenwachstum setzt sich in der HTS-Schicht fort. Die endliche Terrassenbreite hat insbesondere zur Folge, dass die HTS-Kristallite nicht beliebig groß werden können, sondern durch Absätze der nächsten Stufen begrenzt sind. Diese beeinflussen auch das Defektwachstum in der HTS-Schicht. Nukleieren stäbchenförmige, a-Achsen-orientierte Körner, so bleibt auch deren Ausdehnung durch diese Stufen begrenzt Fig. 5 B (a). Zudem können sie durch das schnellere Wachstum in a-b-Richtung von weiter oben liegenden Stufen überwachsen werden Fig. 5 B (b) und dadurch terminieren.

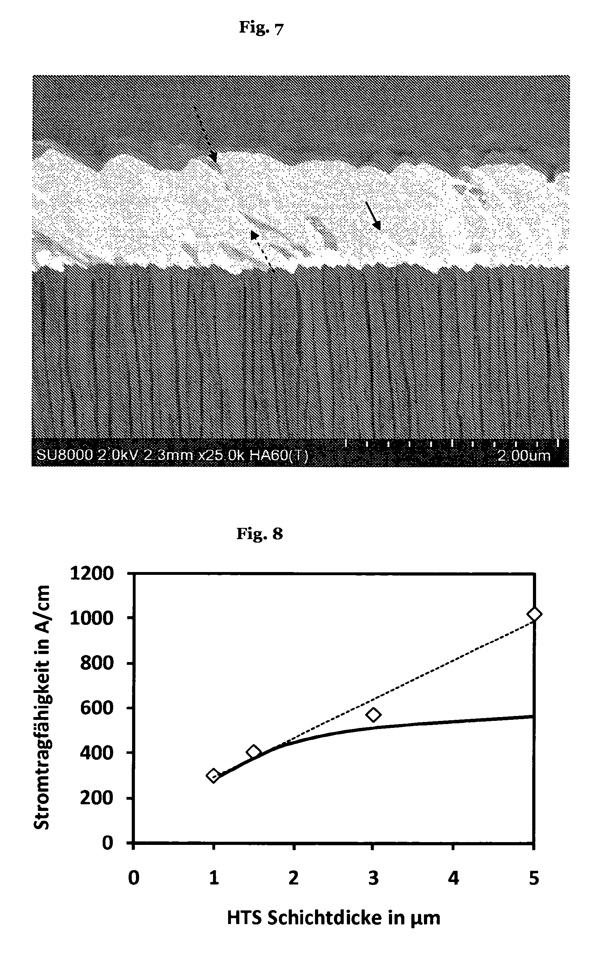

Ganz ähnlich verhält es sich mit eingelagerten Fremdphasen, d.h. Ausscheidungen deren chemische Zusammensetzung sich von der der umgebenden HTS-Schicht unterscheidet. Dies ist im schematischen Querschnitt in der Fig. 6 dargestellt. Bilden sich solche Ausscheidungen im HTS-Film auf glatter Unterlage (Fig. 6 A), so werden sie von der umgebenden HTS-Schicht oft nicht überwachsen (aufgrund unterschiedlicher freier Oberflächenenergie) und lagern im Laufe des fortschreitenden Schichtwachstums zusätzliches Material nach oben hin an (gestrichelt und punktiert dargestellt), so dass sie oft nach oben aus der HTS-Schicht herausragen. Diese meist kupferreichen Ausscheidungen sind in RBCO-Filmen gut bekannt. Wächst die HTS-Schicht auf gestuftem Substrat jedoch terrassenartig (Fig. 6 B), so wird die Ausscheidung, durch das schnelle Wachstum in a-b-Richtung (schräggestellte Ebenen) von höher gelegenen Stufen aus seitlich überwachsen, dargestellt durch die Pfeile (W). Die Anlagerung neuen Materials erfolgt seitlich (gestrichelt und punktiert dargestellt), so dass die Einlagerung entlang der ab-Ebenen erfolgt und den Film nicht vertikal durchsetzt. Stößt die Ausscheidung an einen Absatz, der in der HTS-Schicht zu einer Korngrenze (KG) führt, so kann ihr Wachstum dadurch komplett zum Erliegen kommen. Dies ist sehr eindrucksvoll zu sehen in der elektronenmikroskopischen Querschnittaufnahme der Fig. 7 - einer HTS-Bandleiterprobe, die nach dem ISD-Verfahren hergestellt wurde.

Die Aufnahme zeigt bei 25.000-facher Vergrößerung im unteren Bereich das charakteristische Säulenwachstum der MgO-Schicht und die gestufte Grenzfläche zur helleren HTS-Schicht. In der HTS-Schicht sieht man helle und dunkle Einlagerungen von Fremdphasen (Pfeil), die sich, wie in Fig. 6 B beschrieben, geneigt entlang der verkippten HTS-Ebenen ausdehnen und in den meisten Fällen an Korngrenzen, z.B. markiert durch gestrichelte Pfeile, zum Stillstand kommen.

Auf der HTS-Schicht ist ferner eine dunklere, dünne Siliziumschicht zu sehen, die für die Querschnittpräparation benötigt wurde, sonst aber keine Bedeutung hat. Auch die HTS-Oberfläche weist deutliche Stufen auf, was das Terrassenwachstum belegt. Der Verkippungswinkel der HTS-Schicht ist identisch mit dem der MgO-Terrassen; die Terrassenbreite in der HTS-Schicht ist jedoch deutlich größer. Dies deutet darauf hin, dass kleinere Stufen mit geringer Stufenhöhe im MgO aufgrund der schnellen a-b-Wachstumsgeschwindigkeit und lateraler Diffusion von der HTS-Schicht überwachsen und ausgeglichen werden können.

Auch in Hinblick auf die Sauerstoffbeladung hat das verkippte Wachstum Vorteile, denn die a-b-Ebenen mit ihrem hohen Sauerstoff-Diffusionskoeffizienten liegen nicht parallel zur Oberfläche, sondern sind zur Filmoberfläche hin offen. Dies erleichtert das Eindiffundieren des Sauerstoffs in die Tiefe der HTS-Schicht bis hin zur Puffer-Grenzfläche und verkürzt die Prozesszeit deutlich.

Die obigen Beobachtungen und Ergebnisse führen zu der Erkenntnis, dass viele der üblichen Degradationsmechanismen unterdrückt oder zumindest stark modifiziert werden, solange ein verkipptes Terrassenwachstum in der HTS-Schicht gewährleistet ist. Mit diesem Wachstumsmodus ist es daher möglich, dicke HTS-Schichten mit hohen kritischen Transportströmen herzustellen. Zum Nachweis wurde eine Schichtdickenserie von DyBCO-Schichten auf 2,5 µm dicken MgO-Pufferschichten hergestellt, die durch das ISD-Verfahren gemäß der Patentschrift EP 0 909 340 aufgebracht wurden und eine Verkippung der [001]-Richtung von 25° gegenüber der Substratnormale aufwiesen. Als Substrat diente eine 90 µm dicke, elektropolierte Folie aus Hastelloy C 276. Die DyBCO-Filme wurden durch Elektronenstrahlverdampfen von DyBCO-Pulver bei einer Substrattemperatur von 700°C abgeschieden. Eine 500 nm dicke, oberflächliche Silberkontaktschicht diente zur niederohmigen Kontaktierung und Stromeinspeisung in die HTS-Schicht. Eine Röntgenbeugungsmessung ergab erwartungsgemäß dieselbe Verkippung der HTS c-Achsen von 25° gegenüber der Substratnormale wie in der MgO-Schicht. Aus den jeweils 10 cm langen und 1 cm breiten Bandleiterproben wurden mehrere kurze Stücke herausgeschnitten und auf photolithographischem Wege Messbrücken mit 1,1 mm Breite strukturiert. Über diese Brücken wurde durch Vierpunktmessung der kritische Transportstrom in einem flüssigen Stickstoffbad (77 K) bestimmt. Die Ergebnisse dieser Versuchsreihe sind in der Tabelle 2 und in der Fig. 8 zusammengefasst.

**Tabelle 2: Transportströme in dicken DyBCO-Schichten auf MgO, das mit Hilfe des ISD-Verfahrens hergestellt wurde**

| HTS-Schichtdicke in µm | 1,0 | 1,5 | 3 | 5 |
|---|---|---|---|---|
| Transportstrom in A/cm | 300 | 405 | 570 | 1018 |
| Kritische Stromdichte in MA/cm² | 3,0 | 2,7 | 1,9 | 2,0 |

Tatsächlich wurde in diesen Proben selbst bei HTS-Schichtdicken von deutlich mehr als 3 µm eine deutliche Zunahme des Transportstroms mit wachsender Schichtdicke beobachtet. In HTS-Schichten mit 5 µm Dicke konnten auf die Breite normierte Transportströme größer 1000 A/cm gemessen werden, was einen Weltrekord für homogene HTS-Schichten darstellt. Eine Auftragung der Messwerte in der Fig. 8 und der Vergleich mit dem typischerweise beobachteten Verhalten (durchgezogene Kurve) macht deutlich, dass die Stromtragfähigkeit der HTS-Schichten in Rahmen der Streuung der Messwerte linear mit der Schichtdicke ansteigt (gestrichelte Ausgleichsgerade) und offenbar die üblichen Degradationsmechanismen stark unterdrückt sind. Da mit dieser Schichtdickenserie noch keine Obergrenze erreicht wurde, ist zu erwarten, dass sich die Stromtragfähigkeit durch dickere HTS-Schichten noch weiter verbessern lässt.

Die technische Lehre aus diesen Versuchen ist, dass sich HTS-Bandleiter mit extrem hoher Stromtragfähigkeit herstellen lassen, indem man z.B. durch eine geeignete Unterlage ein Terrassenwachstum in der HTS-Schicht induziert und dadurch dicke HTS-Schichten, bevorzugt über 3 µm Dicke, besonders bevorzugt mit Schichtdicken im Bereich von 5 - 10 µm herstellt. In derart hergestellten HTS-Bandleitern lassen sich bei 77 K bezogen auf die Leiterbreite Transportströme größer 600 A/cm, besonders bevorzugt größer 1000 A/cm erzielen. Als charakteristische Signatur lässt sich in diesen Bandleitern die Verkippung der c-Achse um mindestens 5°, bevorzugt zwischen 20° und 30°, gegenüber der Substratnormale durch Röntgenbeugung nachweisen. Eine Querschnittpräparation zeigt deutliche Stufen der Grenzfläche zwischen Puffer- und HTS-Schicht, wobei die mittlere Stufenhöhe mindestens 20 nm beträgt.

Beispielhaft kann eine geeignete Epitaxieunterlage durch das ISD-Verfahren zur Verfügung gestellt werden. Es sind jedoch auch andere Verfahren denkbar, die allein durch eine entsprechende Prozessführung oder in Kombination mit einer Substratverkippung während der Beschichtung, eine verkippte und gestufte Pufferschicht als Epitaxieunterlage schaffen können. Denkbar wären in diesem Zusammenhang der Einsatz eines unterstützenden Ionenstrahls, bzw. Abwandlungen der bekannten IBAD-Verfahren.

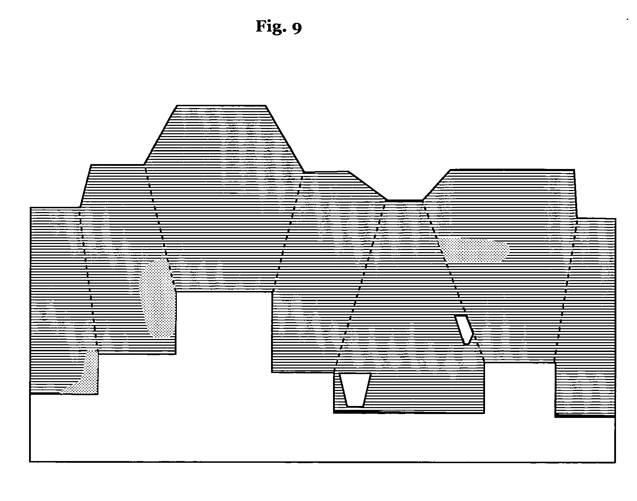

Obwohl die Verkippung der c-Achse gegenüber der Substratnormale deutliche Vorteile in Hinblick auf Defektwachstum und Sauerstoffbeladung mit sich bringt, lässt die obige Betrachtung den Schluss zu, dass sie zur Unterdrückung bzw. Limitierung des Defektwachstums nicht zwingend notwendig ist. Viele der oben diskutierten Mechanismen zum lateralen Überwachsen und zur Begrenzung des Kornwachstums setzen lediglich Stufen in der Oberfläche voraus, die in den HTS-Film hinein übertragen werden. Dies ist in Anlehnung an die Figuren 5 und 6 schematisch in der Fig. 9 dargestellt. Von den Stufen in der Unterlage gehen Korngrenzen aus (gestrichelte Linien). Ausscheidungen (grau) oder a-Achsen-Körner (weiß) können von höher gelegenen Niveaus aus überwachsen und an Terrassenstufen (Korngrenzen) gestoppt werden. Im Unterschied zu den verkippten Terrassen, wo es keine ausgezeichneten Terrassen gibt, können in diesem Fall auf den am höchsten gelegenen Niveaus oder Inseln ähnlich wie auf glatten Substraten Defekte senkrecht bis über die Oberfläche hinaus auftreten. Oberflächenparallele Stufen oder Terrassen im Substrat oder in mindestens einer zwischen Substrat und HTS-Schicht liegenden Pufferschicht können beispielsweise durch anisotropes Ätzen (trocken oder nasschemisch) erzeugt werden.

Unabhängig von der Herstellung der terrassierten Epitaxieunterlage müssen an die Breite der Terrassen und die Höhe der Stufen gewisse Anforderungen gestellt werden, um die Wirksamkeit auf das Schicht- und Defektwachstum zu gewährleisten. Ist die Terrassenbreite deutlich größer, als die typischen, wachstumsbedingten Korngrößen in der HTS-Schicht, so stellen Terrassen keine Beschränkungen des Wachstums dar und bleiben ohne Wirkung. Typischerweise liegen die beobachteten Korngrößen für a-Achsen oder c-Achsen-Wachstum in der Größenordnung von 1 µm. Daher darf die mittlere Terrassenbreite maximal 1 µm betragen. Bevorzugt liegt sie unterhalb von 400 nm.

Bei verkippten Terrassen ist die mittlere Terrassenbreite b über den Verkippungswinkel β direkt mit der mittleren Stufenhöhe h = b × tan β korreliert. Im Winkelbereich zwischen 5° und 30° liegt deshalb die maximale mittlere Stufenhöhe zwischen 85 nm und 600 nm. Unabhängig von der Verkippung müssen die Stufen zudem eine gewisse Mindesthöhe aufweisen, die durch die Größe typischer Defektnuklei und die Mobilität der deponierten Schichtbestandteile auf der Oberfläche gegeben ist. Ist der keimende Defekt höher als die Stufe, oder kann diese leicht überwachsen werden, bleibt sie wirkungslos. Typischerweise liegt die Stufenhöhe wirksamer ISD-Oberflächen im Bereich von 50 nm - 200 nm. Da auch kleinere Abstufungen innerhalb der großen Terrassen auftreten, die keine unmittelbaren Auswirkungen haben, kann die Untergrenze für die Mindeststufenhöhe mit ca. 20 nm angegeben werden. Gute Ergebnisse im Dickenwachstum von HTS-Schichten werden bereits mit mittleren Stufenhöhen von 100 nm erzielt. Werden die Stufen dagegen sehr hoch, wirken sie sich negativ auf den Stromfluss in der HTS-Schicht aus. Ist die Stufenhöhe vergleichbar zur Schichtdicke, wächst die Schicht diskontinuierlich und ist nicht geschlossen. Praktisch sinnvoll erscheint eine maximale Stufenhöhe von bis zu 20% der angestrebten HTS-Schichtdicke, da damit die Beeinträchtigung der Transporteigenschaften der HTS-Schicht in vertretbarem Rahmen bleibt.

## Patentansprüche

1. Hochtemperatur-Supraleiter-Bandleiter mit einem flexiblen Metallsubstrat, aufweisend:
a. zumindest eine Zwischenschicht, die auf dem flexiblen Metallsubstrat angeordnet ist und die auf der dem flexiblen Metallsubstrat gegenüberliegenden Seite Terrassen aufweist,
b. wobei eine mittlere Breite der Terrassen kleiner als 1 µm ist und eine mittlere Höhe der Terrassen größer als 20 nm ist; und
c. zumindest eine auf der Zwischenschicht angeordnete Hochtemperatur-Supraleiter-Schicht, die auf der zumindest einen Zwischenschicht angeordnet ist und eine Schichtdichte größer als 3 µm aufweist, und
d. wobei die auf die Leiterbreite bezogene Stromtragfähigkeit des Hochtemperatur-Supraleiter-Bandleiters bei 77 K größer als 600 A/cm ist.

2. Hochtemperatur-Supraleiter-Bandleiter nach Anspruch 1, wobei die Hochtemperatur-Supraleiter-Schicht eine Schichtdicke von 5 µm bis 10 µm aufweist.

3. Hochtemperatur-Supraleiter-Bandleiter nach einem der Ansprüche 1 oder 2, wobei die mittlere Höhe der Terrassen der zumindest einen Zwischenschicht einen Bereich von 50 nm bis 200 nm umfasst.

4. Hochtemperatur-Supraleiter-Bandleiter nach einem der vorhergehenden Ansprüche, wobei die maximale mittlere Höhe der Terrassen der zumindest einen Zwischenschicht 20% der Schichtdicke der Hochtemperatur-Supraleiter-Schicht nicht überschreitet.

5. Hochtemperatur-Supraleiter-Bandleiter nach einem der vorhergehenden Ansprüche, wobei die mittlere Breite der Terrassen der zumindest einen Zwischenschicht kleiner als 400 nm ist.

6. Hochtemperatur-Supraleiter-Bandleiter nach einem der vorhergehenden Ansprüche, wobei das Metallsubstrat eine Folie aus Hastelloy mit einer Dicke bis 200 µm umfasst.

7. Hochtemperatur-Supraleiter-Bandleiter nach einem der vorhergehenden Ansprüche, wobei die zumindest eine Zwischenschicht eine Magnesiumoxid-Schicht mit einer Dicke von 1,5 µm bis 3,5 µm umfasst.

8. Hochtemperatur-Supraleiter-Bandleiter nach einem der vorhergehenden Ansprüche, wobei die Hochtemperatur-Supraleiter-Schicht eine RBa₂Cu₃O₇ Schicht umfasst, wobei R ein Element aus der Gruppe umfasst, die die Elemente Dysprosium (Dy), Gadolinium (Gd), Holmium (Ho) und Yttrium (Y) beinhaltet, insbesondere eine Hochtemperatur-Supraleiter-Schicht aus Dy-Ba₂Cu₃O₇. umfasst.

9. Hochtemperatur-Supraleiter-Bandleiter nach Anspruch 1 oder 2, wobei die Oberfläche der Terrassen im Wesentlichen parallel zu der Metallsubstratebene ist.

10. Hochtemperatur-Supraleiter-Bandleiter nach Anspruch 9, wobei die Terrassen der zumindest einen Zwischenschicht durch anisotropes Ätzen hergestellt werden.

## Claims

1. High temperature superconducting tape conductor with a flexible metal substrate, comprising:
a. at least one intermediate layer that is arranged on the flexible metal substrate and which comprises terraces at the side that is opposed to the flexible metal substrate, wherein
b. a mean width of the terraces is less than 1 µm and a mean height of the terraces is more than 20 nm, and
c. at least one high temperature superconducting layer that is arranged on the intermediate layer, which is arranged on the at least one intermediate layer and comprises a layer thickness of more than 3 µm, and
d. wherein the ampacity that is related to the conductor width of the high temperature superconducting tape conductor is higher than 600 A/cm at 77 K.

2. High temperature superconducting tape conductor according to claim 1, wherein the high temperature superconducting layer comprises a layer thickness of 5 µm to 10 µm.

3. High temperature superconducting tape conductor according to one of the claims 1 or 2, wherein the mean height of the terraces of the at least one intermediate layer comprises a range of 50 nm to 200 nm.

4. High temperature superconducting tape conductor according to one of the preceding claims, wherein the maximum mean height of the terraces does not exceed 20 % of the layer thickness of the high temperature superconducting layer.

5. High temperature superconducting tape conductor according to one of the preceding claims, wherein the mean width of the terraces of the at least one intermediate layer is less than 400 nm.

6. High temperature superconducting tape conductor according to one of the preceding claims, wherein the metal substrate comprises a sheet made of Hastelloy with a thickness of up to 200 µm.

7. High temperature superconducting tape conductor according to one of the preceding claims, wherein the at least one intermediate layer comprises a magnesium oxide layer with a thickness of 1,5 µm to 3,5 µm.

8. High temperature superconducting tape conductor according to one of the preceding claims, wherein the high temperature superconducting layer comprises a RBa₂Cu₃O₇-layer, wherein R is one element from the group consisting of the elements Dysprosium (Dy), Gadolinium (Gd), Holmium (Ho) and Yttrium (Y), in particular a high temperature superconducting layer consisting of DyBa₂Cu₃O₇.

9. High temperature superconducting tape conductor according to one of the claims 1 or 2, wherein the surface of the terraces is essentially parallel to the metal substrate plane.

10. High temperature superconducting tape conductor according to claim 9, wherein the terraces of the at least one intermediate layer are manufactured by anisotropic etching.

## Revendications

1. Conducteur plat supraconducteur à haute température avec un substrat métallique flexible, comprenant :
a. au moins une couche intermédiaire qui est disposée sur le substrat métallique flexible et qui, du côté opposé au substrat métallique flexible, comporte des terrasses,
b. une largeur moyenne des terrasses étant inférieure à 1 µm, et une hauteur moyenne des terrasses étant supérieure à 20 nm ; et
c. au moins une couche supraconductrice à haute température qui est disposée sur la couche intermédiaire, qui est disposée sur ladite au moins une couche intermédiaire et qui présente une épaisseur de couche supérieure à 3 µm, et
d. le courant admissible du conducteur plat supraconducteur à haute température par rapport à la largeur de conducteur étant supérieur à 600 A/cm à 77 K.

2. Conducteur plat supraconducteur à haute température selon la revendication 1, dans lequel la couche supraconductrice à haute température présente une épaisseur de couche de 5 µm à 10 µm.

3. Conducteur plat supraconducteur à haute température selon l'une des revendications 1 ou 2, dans lequel la hauteur moyenne des terrasses de ladite au moins une couche intermédiaire se situe dans une plage de 50 nm à 200 nm.

4. Conducteur plat supraconducteur à haute température selon l'une des revendications précédentes, dans lequel la hauteur moyenne maximale des terrasses de ladite au moins une couche intermédiaire ne dépasse pas 20 % de l'épaisseur de couche de la couche supraconductrice à haute température.

5. Conducteur plat supraconducteur à haute température selon l'une des revendications précédentes, dans lequel la largeur moyenne des terrasses de ladite au moins une couche intermédiaire est inférieure à 400 nm.

6. Conducteur plat supraconducteur à haute température selon l'une des revendications précédentes, dans lequel le substrat métallique comprend une feuille en Hastelloy d'une épaisseur allant jusqu'à 200 µm.

7. Conducteur plat supraconducteur à haute température selon l'une des revendications précédentes, dans lequel ladite au moins une couche intermédiaire comprend une couche d'oxyde de magnésium d'une épaisseur de 1,5 µm à 3,5 µm.

8. Conducteur plat supraconducteur à haute température selon l'une des revendications précédentes, dans lequel la couche supraconductrice à haute température comprend une couche de RBa₂Cu₃O₇, où R est un élément du groupe constitué du dysprosium (Dy), du gadolinium (Gd), de l'holmium (Ho) et de l'yttrium (Y), en particulier une couche supraconductrice à haute température en DyBa₂Cu₃O₇.

9. Conducteur plat supraconducteur à haute température selon la revendication 1 ou 2, dans lequel la surface des terrasses est sensiblement parallèle au plan du substrat métallique.

10. Conducteur plat supraconducteur à haute température selon la revendication 9, dans lequel les terrasses de ladite au moins une couche intermédiaire sont réalisées par gravure anisotrope.
